# FASCICULE DE BREVET EUROPEEN

(11) **EP 2 365 741 B1**
(45) Date de publication et mention de la délivrance du brevet: **19.09.2018**
(21) Numéro de dépôt: 11157121.2
(22) Date de dépôt: 07.03.2011
(51) Int. Cl.: H05K 3/34, H01L 21/768, H01L 23/00, H01L 21/683

(54) **PROCEDE DE METALLISATION DE VIAS BORGNES**
VERFAHREN ZUR METALLISIERUNG VON BLINDLÖCHERN
METHOD FOR METALLIZING BLIND VIAS

(30) Priorité: 10.03.2010 FR 1051726
(43) Date de publication de la demande: 14.09.2011
(73) Titulaire: Commissariat à l'Énergie Atomique et aux Énergies Alternatives, 75015 Paris (FR)
(72) Inventeur: Jacuet, Fabrice, 38220 SAINT PIERRE DE MESAGE (FR); Bolis, Sébastien, 38920 CROLLES (FR); Saint-Patrice, Damien, 26120 CHABEUIL (FR)
(74) Mandataire: Ilgart, Jean-Christophe

(56) Documents cités:
- EP-A2- 1 650 797
- JP-A- 2003 092 467
- US-A1- 2004 261 636
- US-A1- 2006 008 627
- US-A1- 2006 177 568
- US-A1- 2008 242 079
- US-A1- 2010 154 211

## Description

### DOMAINE TECHNIQUE

L'invention concerne le domaine de la microélectronique et notamment la métallisation d'au moins un via borgne formé dans au moins un substrat. L'invention s'applique particulièrement pour réaliser une métallisation simultanée de plusieurs vias borgnes formés dans au moins un substrat.

L'invention pourra être utilisée en microélectronique pour la réalisation d'interconnexions électriques et/ou de reprises de contacts électriques dans un substrat, ou wafer, microélectronique, c'est-à-dire servant de support pour la réalisation d'un ou plusieurs dispositifs microélectroniques.

L'invention est particulièrement adaptée pour réaliser une ou plusieurs interconnexions électriques entre deux substrats par la métallisation d'un ou plusieurs vias borgnes formés dans au moins un des deux substrats, ou encore pour réaliser une reprise de contacts électriques dans un dispositif imageur.

### ÉTAT DE LA TECHNIQUE ANTÉRIEURE

Il est connu de réaliser des interconnexions électriques ou des reprises de contacts électriques dans un substrat en formant des vias, c'est-à-dire des trous ou des cavités, dans ce substrat, puis en réalisant une métallisation de ces via, c'est-à-dire en les remplissant avec un matériau électriquement conducteur tel que du métal.

Une telle métallisation de vias formés dans un substrat peut être obtenue en mettant en oeuvre des procédés classiques de dépôt sous vide, par exemple de type PVD (dépôt physique en phase vapeur), PECVD (dépôt chimique en phase vapeur assisté par plasma), électrolyse, etc. Ces procédés sont adaptés pour métalliser des vias de faibles diamètres, par exemple inférieurs à environ 100 µm, et de faibles profondeurs. Le document "New Front to Back-side 3D Interconnects Based High Aspect Ratio Through Silicon Vias" par Mohamed Saadaoui et Al., 10th EPTC, Singapore, décrit un procédé dans lequel les vias sont métallisés par une électrolyse réalisée de manière ascendante, c'est-à-dire de type « bottom-up ».

Toutefois, ces procédés deviennent inappropriés lorsque l'on souhaite métalliser des vias de plus grandes profondeurs, par exemple dans le cas de vias traversant réalisés dans toute l'épaisseur d'un substrat de silicium dont l'épaisseur standard est égale à environ 720 µm, et cela même pour des vias comprenant des motifs de grandes dimensions, c'est-à-dire comprenant un diamètre supérieur ou égal à environ 200 µm, en raison des temps de mise en oeuvre nécessaires extrêmement longs, et donc du coût de revient pour réaliser de telles métallisations.

Afin de réduire ce coût, il est également connu de réaliser une métallisation de vias par sérigraphie : le matériau électriquement conducteur est disposé sur le substrat sous la forme d'une pâte puis, par l'intermédiaire d'une racle, cette pâte est introduite dans les vias.

Cependant, une telle métallisation par sérigraphie pose des problèmes dans le cas de vias dits « borgnes », c'est-à-dire de vias non traversant qui débouchent au niveau d'une seule face du substrat et qui comportent une paroi de fond. Les défauts les plus fréquents alors rencontrés sont l'emprisonnement de bulles d'air dans les vias, sous le matériau électriquement conducteur, et/ou un remplissage partiel des vias empêchant de réaliser ultérieurement une reprise des contacts électriques formés par les vias du côté des parois de fond des vias. De plus, la sérigraphie n'est pas non plus adaptée pour métalliser des vias ayant un facteur de forme (rapport de la profondeur sur le diamètre du via) important, par exemple supérieur à 2.

Pour palier à ces problèmes, le document JP 2002/144523 A propose de réaliser une métallisation de vias par la mise en oeuvre d'une sérigraphie sous vide. Toutefois, les inconvénients liés à la mise en oeuvre d'une telle sérigraphie sous vide sont nombreux :
- les modifications devant être apportées au matériel de sérigraphie pour réaliser une telle sérigraphie sous vide sont très coûteuses,
- le temps nécessaire à la mise sous vide du substrat avant de procéder à la sérigraphie est important,
- le matériau de sérigraphie utilisé pour métalliser les vias doit être compatible avec une mise sous vide, ce qui impose d'utiliser un composite polymère/métal comme matériau de métallisation,
- la qualité de l'interconnexion électrique obtenue par exemple entre le matériau de métallisation sérigraphié et des parois électriquement conductrices du via est aléatoire.

Le document JP 2003/092467 A décrit un procédé de métallisation d'un via borgne formé dans un substrat, dans lequel une portion solide de matériau électriquement conducteur est tout d'abord disposée dans le via borgne. Un traitement thermique permet ensuite de faire fondre cette portion solide de matériau conducteur dans le via borgne. Le matériau conducteur est ensuite solidifié.

### EXPOSÉ DE L'INVENTION

Un but de la présente invention est de proposer un procédé de métallisation d'au moins un via borgne ne posant pas les problèmes des procédés de l'art antérieur, c'est-à-dire s'affranchissant des problèmes d'emprisonnement d'air dans le via, qui soit adapté quelques soient les dimensions du via aussi bien en termes de facteur de forme que de profondeur et de dimensions de section du via, qui soit peut coûteux et rapide, et pouvant être mis en oeuvre à partir de n'importe quel matériau de métallisation,

Pour cela, la présente invention propose un procédé de métallisation d'au moins un via borgne formé dans au moins un substrat, comportant au moins les étapes suivantes :
a) disposer au moins une portion solide de matériau électriquement conducteur dans le via borgne,
b) réaliser un traitement thermique de la portion solide de matériau électriquement conducteur, la faisant fondre dans le via borgne,
c) réaliser un refroidissement du matériau électriquement conducteur, le solidifiant dans le via borgne.

Ainsi, lors du traitement thermique du substrat faisant fondre le matériau électriquement conducteur, qui forme donc un matériau fusible, ce dernier s'écoule donc progressivement dans le via, permettant à l'air de s'échapper compte tenu du fait que la fonte du matériau électriquement conducteur est progressive et que des espaces libres entre l'intérieur du via et l'environnement extérieur forment des canaux par lesquels l'air peut s'échapper.

De plus, en faisant appel à une ou plusieurs portions solides de matériau électriquement conducteur de dimensions adaptées, c'est-à-dire dont les dimensions sont inférieures à celles du via, il est donc possible de réaliser une métallisation d'un via quelque soit son rapport de forme et ses dimensions.

Le procédé de métallisation selon l'invention s'applique à au moins un via borgne, c'est-à-dire un via formé dans au moins un substrat, qui d'un premier côté est débouchant au niveau d'une face du substrat, et d'un second côté, opposé au premier côté, comporte une paroi de fond. Cette paroi de fond peut être temporaire, c'est-à-dire servant à la métallisation du via selon le procédé de l'invention dans un premier temps, puis étant ensuite supprimée permettant d'accéder au via depuis deux côtés opposés.

On entend par substrat une structure homogène (c'est-à-dire comportant une seule couche) ou une structure hétérogène (c'est-à-dire comportant un ensemble de couches), et peut également désigner un empilement de substrats.

Avantageusement, lors de l'étape a), on peut disposer une pluralité de portions solides d'au moins un matériau électriquement conducteur dans le via, dont les dimensions (par exemple le diamètre lorsque les portions solides sont des microbilles) sont inférieures à celle du diamètre du via. Par exemple, pour un via dont la section a une dimension (par exemple le diamètre) égale à environ 30 µm, il est possible d'utiliser au moins une microbille de diamètre inférieur ou égal à environ 25 µm. Ainsi, les espaces entre les portions solides forment des canaux permettant à l'air de s'échapper lorsque l'on fait fondre ces portions solides de matériau électriquement conducteur.

Avantageusement, la portion solide de matériau électriquement conducteur peut être une microbille. Une telle microbille a notamment pour avantage d'être facilement déplaçable sur la surface du substrat au niveau de laquelle le via borgne est débouchant en la faisant rouler, afin de la disposer aisément dans le via.

Préalablement à l'étape a), la microbille peut être disposée sur une face du substrat au niveau de laquelle le via borgne est débouchant, puis poussée et/ou roulée dans le via borgne au cours de l'étape a).

Ainsi, par exemple, au cours de l'étape a), la microbille peut être disposée dans le via borgne par l'intermédiaire d'une racle déplacée relativement à ladite face du substrat et/ou en faisant rouler la microbille sur ladite face du substrat.

De manière alternative, préalablement à l'étape a), la portion solide de matériau électriquement conducteur peut être disposée sur une face du substrat au niveau de laquelle le via borgne est débouchant, et, au cours de l'étape a), la portion solide de matériau électriquement conducteur peut être disposée dans le via borgne par une mise en vibration du substrat.

Préalablement à la mise en oeuvre de l'étape a), au moins une partie des parois du via borgne est recouverte d'un matériau apte à empêcher le mouillage de ladite partie des parois du via borgne par le matériau électriquement conducteur fondu obtenu lors de la mise en oeuvre de l'étape b), le matériau électriquement conducteur solidifié obtenu après la mise en oeuvre de l'étape c) étant non solidaire, ou isolé, de ladite partie des parois du via borgne non mouillante. L'angle de goutte formé entre le matériau électriquement conducteur fondu puis solidifié et le matériau recouvrant ladite partie des parois peut être sensiblement proche d'environ 180°, et au moins supérieur à environ 90°C. Ainsi, il est possible de former dans le via une métallisation qui n'est pas en contact avec une partie et/ou certaines des parois du via, par exemple les parois latérales du via, formant ainsi un « pilier » de matériau électriquement conducteur dans le via qui n'est pas en contact avec ces parois du via.

Du fait que le matériau électriquement conducteur ne mouille pas les parois du via, on obtient un découplage mécanique du matériau électriquement conducteur solidifié (pilier) vis-à-vis du substrat. Or, la différence entre le coefficient de dilatation thermique du matériau électriquement conducteur (par exemple égal à environ 17 ppm/°C pour du cuivre ou supérieur à environ 20 ppm/°C pour certains alliages conducteurs) et le coefficient de dilatation thermique du matériau du substrat (par exemple égal à environ 2,6 ppm/°C pour du silicium ou égal à environ 3,3 ppm/°C pour du verre type borofloat) entraîne des contraintes mécaniques lors des traitements thermiques ou lors de l'utilisation de composants, pouvant entraîner une rupture mécanique de l'ensemble. Le découplage mécanique ainsi réalisé entre le matériau électriquement conducteur solidifié et le substrat améliore donc la robustesse de l'ensemble réalisé.

De plus, lorsque le matériau électriquement conducteur ne mouille pas les parois du via, l'espace formé entre le matériau électriquement conducteur solidifié et le substrat permet d'obtenir une isolation électrique entre le substrat (les parois du via) et le matériau électriquement conducteur solidifié.

De manière alternative, préalablement à la mise en oeuvre de l'étape a), au moins une partie des parois du via borgne peuvent être recouvertes d'un matériau apte à rendre ladite partie des parois du via borgne mouillable par le matériau électriquement conducteur fondu obtenu lors de la mise en oeuvre de l'étape b), le matériau électriquement conducteur solidifié obtenu après la mise en oeuvre de l'étape c) pouvant être en contact avec ladite partie des parois du via borgne mouillable.

Ainsi, il est possible soit de remplir complètement le via avec le matériau électriquement conducteur, soit de réaliser une couche à base du matériau électriquement conducteur le long des parois rendues mouillables du via, et cela en fonction des dimensions et du nombre de portions solides disposées dans le via lors de l'étape a).

Le via borgne peut traverser le substrat, appelé premier substrat, tel que le via borgne soit débouchant au niveau de deux faces opposées du premier substrat, une paroi de fond du via borgne étant formée par au moins un second substrat solidarisé au premier substrat. Ce second substrat peut être un élément solidarisé en permanence au premier substrat, par exemple lorsque les deux substrats font partie d'un dispositif microélectronique, ou bien être un élément solidarisé temporairement au premier substrat afin de former une paroi de fond temporaire du via borgne, ce second substrat pouvant être ensuite séparé du premier substrat après la métallisation du via.

Au moins un contact électrique peut être disposé sensiblement au niveau d'une paroi de fond du via borgne, et/ou sur au moins une face du substrat au niveau de laquelle le via borgne est débouchant et tout ou partie en périphérie du via borgne, le matériau électriquement conducteur solidifié obtenu après la mise en oeuvre de l'étape c) pouvant être relié électriquement audit contact électrique. Ainsi, la métallisation du via peut former une connexion reliée électriquement à ce(s) contact(s).

La mise en oeuvre des étapes a) à c) peut être répétée plusieurs fois, augmentant la quantité de matériau électriquement conducteur solidifié dans le via borgne à chaque mise en oeuvre ultérieure de l'étape c) par rapport à la quantité de matériau électriquement conducteur solidifié lors d'une précédente mise en oeuvre de l'étape c).

Dans ce cas, lors d'une mise en oeuvre ultérieure de l'étape a), les dimensions de la portion solide de matériau électriquement conducteur utilisée peuvent être inférieures aux dimensions de la portion solide de matériau électriquement conducteur utilisée lors d'une précédente mise en oeuvre de l'étape a).

La mise en oeuvre des étapes a) à c) peut réaliser simultanément la métallisation de plusieurs vias borgnes formés au moins dans le substrat.

Dans ce cas, préalablement à la mise en oeuvre de l'étape a), un masque peut être disposé sur une face du substrat au niveau de laquelle les vias borgnes sont débouchant, le masque pouvant comporter au moins une ouverture alignée avec au moins un des vias borgnes. Un tel masque permet donc de sélectionner les vias à métalliser et d'obturer d'autres vias également formés dans le substrat ne devant pas être métallisés. De plus, un tel masque permet également de protéger les zones du substrat sur lesquelles on souhaite éviter la formation de métallisations intempestives.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1F représentent les étapes d'un procédé de métallisation d'un via borgne selon un premier mode de réalisation,
- les figures 2A à 2D représentent les étapes d'un procédé de métallisation de vias borgnes selon un second mode de réalisation,
- la figure 3 représente un via métallisé par la mise en oeuvre d'une procédé de métallisation, objet de la présente invention, selon une variante du premier mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

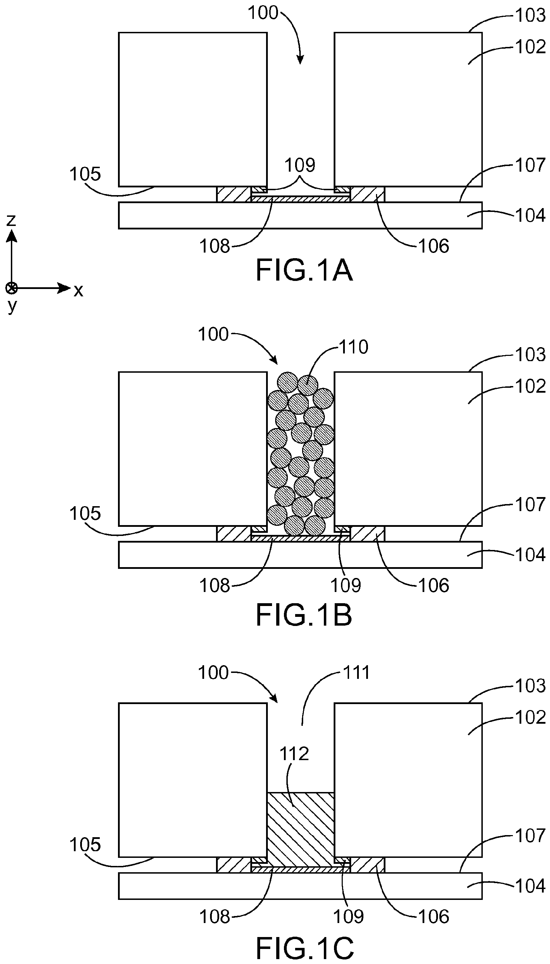

On se réfère tout d'abord aux figures 1A à 1F qui représentent les étapes d'un procédé de métallisation d'un via borgne 100 selon un premier mode de réalisation.

Comme représenté sur la figure 1A, le via borgne 100 est réalisé dans une structure comportant un premier substrat 102 solidarisé à un second substrat 104 par une interface de scellement 106. Les premier et second substrats 102 et 104 sont par exemple à base de silicium et chacun d'épaisseur (dimension selon l'axe Z représenté sur la figure 1A) égale à environ 720 µm. Le via 100 a par exemple une section, dans le plan (X,Y) et au niveau du premier substrat 102, sensiblement en forme de disque et de diamètre par exemple égal à environ 100 µm.

Le via 100 traverse le premier substrat 102 et est donc débouchant à la fois au-niveau d'une face supérieure 103 du premier substrat 102 et d'une face inférieure 105 du premier substrat 102. Une paroi de fond du via borgne 100 est formée par une partie d'une face supérieure 107 du second substrat 104 qui se trouve en regard de l'espace vide formé par le via 100 dans le premier substrat 102. Un contact électrique 108, par exemple à base d'un matériau électriquement conducteur tel que du métal (par exemple de l'or), est disposé au niveau de cette paroi de fond du via 100. De plus, des contacts électriques 109 sont également présents dans le via 100, au niveau de la face inférieure 105 du premier substrat 102. Bien que non représentés, des dispositifs microélectroniques (transistors, capteurs CMOS, etc.) sont réalisés sur le premier substrat 102 et/ou le second substrat 104 et sont reliés électriquement aux contacts électriques 108 et 109. Dans une variante, il est également possible que des contacts électriques soient également disposés au niveau de la face supérieure 103 du substrat 102, en périphérie du via 100.

Comme représenté sur la figure 1B, une pluralité de microbilles 110 à base d'un matériau électriquement conducteur sont disposées dans le via borgne 100. Pour cela, les microbilles 110 sont par exemple tout d'abord disposées sur la face supérieure 103 du premier substrat 102, puis amenées dans le via 100 par l'intermédiaire d'une racle, par exemple similaire à une racle utilisée pour mettre en oeuvre une sérigraphie, qui est amène les microbilles 110 dans le via borgne 100. Sur l'exemple de la figure 1B, le via borgne 100 est rempli par les microbilles 110. Dans une variante, il est également possible de faire rouler les microbilles 110 sur la face supérieure 103 du substrat 102 sans utiliser de racle, jusqu'à ce qu'un nombre suffisant de microbilles 110 soient disposées dans le via borgne 100.

Le matériau électriquement conducteur des microbilles 110 est ici un alliage fusible, par exemple un alliage à base d'étain, d'argent et de cuivre. Le matériau électriquement conducteur utilisé pourra être choisi par exemple en fonction du matériau du substrat 102 et/ou du matériau des contacts électriques destinés à être en contact avec le matériau de métallisation (les contacts électriques 108 et 109 dans ce premier mode de réalisation), et par exemple à base de cuivre et/ou d'or et/ou de nickel. On prendra soin à choisir, pour les microbilles 110, un matériau dont la température de fusion est inférieure à celles des matériaux des autres éléments, notamment des contacts électriques. Les diamètres des microbilles 110 sont inférieurs à celui du via borgne 100. Sur l'exemple de la figure 1B, les microbilles 110 ont toutes un diamètre sensiblement similaire. Toutefois, il est possible de remplir le via borgne 100 avec des microbilles 110 de diamètres différents, ce qui peut permettre d'augmenter la compacité de remplissage du via borgne 100, c'est-à-dire de réduire l'espace vide inoccupé par les microbilles 110 dans le via borgne 100 lorsque celui-ci est rempli par les microbilles 110.

Le tableau ci-dessous donne les caractéristiques dimensionnelles de différents types de microbilles pouvant être utilisées dans le procédé de métallisation.

| Type désignation | Diamètre maximum | Diamètre nominal | Gamme de diamètres |
|---|---|---|---|
| Type 2 | | | 75 - 45 |
| Type 3 | | | 45 - 20 |
| Type 4 | | | 38 - 20 |
| Type 5 | 30 µm | 25 µm | 25 - 10 |
| Type 6 | 20 µm | 15 µm | 15 - 5 |
| Type 7 | 15 µm | 11 µm | 11 - 2 |
| Type 8 | 11 µm | 10 µm | 8 - 2 |

La valeur indiquée dans la colonne « diamètre maximum » correspond au diamètre maximum que peut avoir une microbille du type en question. La valeur indiquée dans la colonne « Diamètre nominal » correspond au diamètre maximum qu'au plus 1 % des microbilles de ce type peuvent avoir. Enfin, la gamme de valeurs indiquée dans la colonne « Gamme de diamètres » correspond à la gamme des diamètres d'au moins 90 % des microbilles du type en question.

En réalisant les microbilles 110 à partir de nanoparticules d'alliage, il est possible de réaliser des microbilles de diamètre encore plus petit que ceux indiqués dans le tableau ci-dessus. De plus, il n'y a pas de limite technologique concernant la taille maximale possible des microbilles 110.

On fait ensuite subir un traitement thermique à l'ensemble dans lequel est réalisé le via borgne 100, c'est-à-dire les substrats 102, 104, afin de faire fondre les microbilles 110. La température nécessaire pour faire fondre les microbilles dépend de la température de fusion du matériau des microbilles 110. Le tableau ci-dessous indique les températures liquidus d'alliages pouvant être utilisés pour réaliser les microbilles 110.

| Alliage | Température Liquidus (°C) |
|---|---|
| 34Sn / 46Bi / 20Pb | 100 |
| 42Sn / 58Bi | 138 |
| 43Sn / 43Pb / 14Bi | 163 |
| 62Sn / 36Pb / 2Ag | 179 |
| 63Sn / 37Pb | 183 |
| 95,5Sn / 3,8Ag / 0,7Cu | 217 |
| 96,5Sn / 3,5Ag | 221 |
| 99,3Sn / 0,7Cu | 227 |
| 80Au / 20Sn | 280 |

En faisant fondre le matériau électriquement conducteur des microbilles 110, celui-ci s'écoule au fond du via borgne 100. Or, étant donné que des espaces vides sont présents entre les microbilles 110 lorsque celles-ci sont disposées dans le via borgne 100, l'air se trouvant sous les microbilles 110 peut donc s'échapper par ces espaces vides, ce qui permet de métalliser le via borgne 100 sans former de bulles d'air sous la métallisation. Comme représenté sur la figure 1C, le matériau fondu des microbilles 110 est ensuite refroidi, formant une portion 112 de matériau électriquement conducteur solidifié qui correspond à une partie de la métallisation du via borgne 100. Cette portion 112 est en contact avec les contacts électriques 108 et 109. Un espace vide 111 est présent dans le via borgne 100, au-dessus de la portion 112 de matériau électriquement conducteur solidifié, entre la première partie 112 de la métallisation et l'ouverture du via borgne 100 se trouvant au niveau de la face supérieure 103 du premier substrat 102. Cet espace vide 111 correspond sensiblement aux espaces vides présents entre les microbilles 110 avant que celles-ci ne soient fondues.

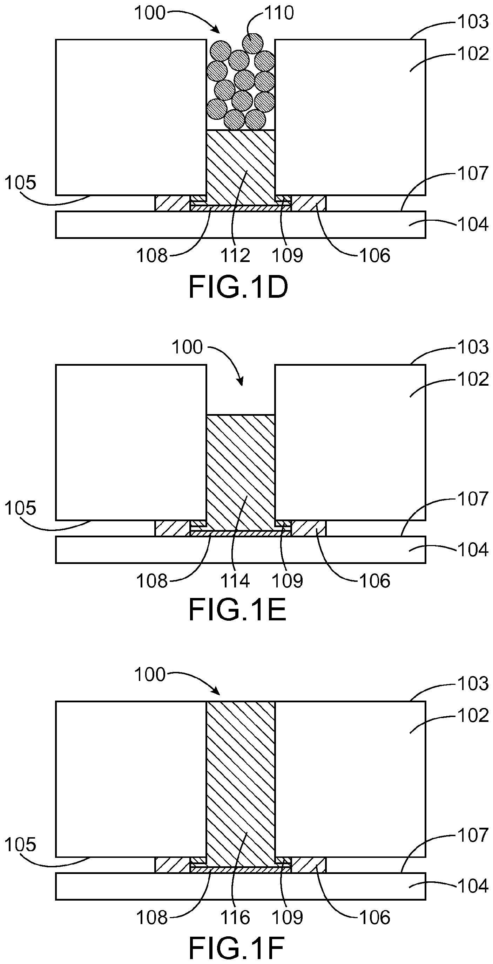

Comme représenté sur la figure 1D, l'opération est ensuite répétée en remplissant l'espace vide 111 par des microbilles 110 par exemple similaires à celles utilisées lors du précédent remplissage du via borgne 100.

Un nouveau traitement thermique est alors mis en oeuvre pour faire fondre ces microbilles 110. Le matériau fondu obtenu se mélange alors avec le matériau de la portion 112 de métallisation qui fond également étant donné qu'il subit le même traitement thermique que les microbilles 110.

Préalablement à la mise en oeuvre de ce nouveau traitement thermique, il est possible de traiter au préalable la portion 112 de métallisation par une étape de désoxydation de sa surface lors de sa refusion. Une telle étape de désoxydation peut être obtenue par un traitement à base d'acide formique.

Après refroidissement, on obtient une portion 114 de matériau électriquement conducteur solidifié occupant dans le via borgne 100 un volume plus important que la précédente portion 112 de matériau de métallisation solidifié précédemment réalisée (figure 1E).

Ces opérations de remplissage de l'espace restant du via borgne 100 par des microbilles 110, de traitement thermique faisant fondre les microbilles 110, puis de refroidissement du matériau fondu sont répétées jusqu'à ce que le via borgne 100 soit entièrement rempli de matériau électriquement conducteur, formant une métallisation 116 telle que représentée sur la figure 1F. La métallisation 116 ainsi réalisée forme donc à la fois une reprise de contact accessible depuis la face supérieure 103 du premier substrat 102 et qui est reliée électriquement aux contacts 108 et 109, ainsi qu'une interconnexion électrique entre les contacts 108 et 109.

La mise en oeuvre de ce procédé permet de remplir totalement le via borgne 100 par un matériau de métallisation, et cela sans que des bulles d'air soient emprisonnées dans ou sous le matériau électriquement conducteur de la métallisation.

Dans l'exemple de procédé précédemment décrit, les microbilles 110 utilisées au cours des différentes étapes du procédé ont toutes un diamètre sensiblement similaire. Dans une variante, il possible d'utiliser au cours du procédé des microbilles de tailles de plus en plus petites à mesure que la partie de métallisation obtenue après refroidissement se rapproche de la face supérieure 103 du second substrat 102. Ainsi, dans les étapes précédemment décrites, les microbilles disposées sur la portion 112 (celles représentées sur la figure 1D) pourraient avoir un diamètre inférieure à celui des microbilles initialement disposées dans le via borgne (celles représentées sur la figure 1A).

Dans ce premier mode de réalisation, le second substrat 104 est solidarisé au premier substrat 102 de manière permanente par l'intermédiaire de l'interface de scellement 106. Dans une variante de réalisation, il est possible que le second substrat 104 ne soit solidarisé que temporairement au premier substrat 102, le temps que les vias soient métallisés. Ce second substrat serait donc utilisé pour former des parois de fond temporaires des vias 100.

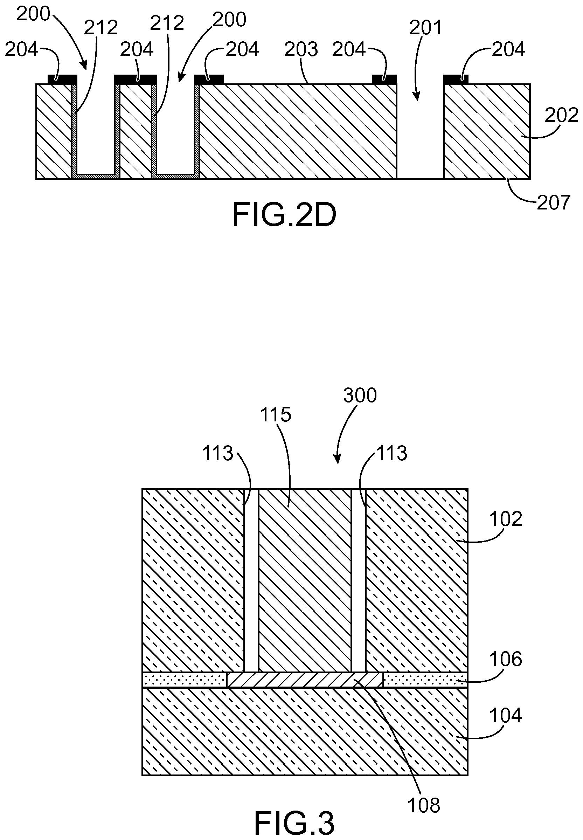

On se réfère à la figure 3 qui représente un via borgne 300 métallisé selon une variante du procédé précédemment décrit en liaison avec les figures 1A à 1F.

De manière analogue au via 100 décrit en liaison avec les figures 1A à 1F, le via borgne 300 est formé à travers le premier substrat 102, le second substrat 104 étant relié au premier substrat 102 par l'intermédiaire de l'interface de scellement 106. Un contact électrique 108 est disposé au fond du via borgne 300.

Dans cette variante, des parois latérales 113 du via borgne 300 sont préalablement traitées afin de les rendre non-mouillantes vis-à-vis du matériau des microbilles 110. Un tel traitement peut consister à réaliser un dépôt de matériau fluoré, par exemple de type CF₄, C₄F₈, ou CHF₃, par traitement plasma, par exemple par PECVD, contre les parois latérales 113 du via borgne 300. Un tel traitement de surface forme un dépôt très mince (quelques couches atomiques ou quelques nanomètres) de matériau fluoré contre les parois 113. Il est également possible de rendre les parois 113 non mouillantes en traitant la surface de ces parois par un revêtement de type polydiméthyl-siloxane (PDMS) ou de type silicone ou téflon (ou un dérivé de ces composants), par exemple déposé par spray.

Dans ce cas, lors de la fonte et du refroidissement du matériau de métallisation, celui-ci s'agglomère sans mouiller les parois latérales 113 du via borgne 300. Le matériau électriquement conducteur solidifié 115 forme donc dans le via 300 un « pilier » qui n'est pas en contact avec les parois latérales 113 du via borgne 300.

Ainsi, l'espace entre les parois 113 du via borgne 300 et la portion de matériau électriquement conducteur solidifié 115 permet d'isoler latéralement le contact électrique, formé par le contact 108 relié à la portion conductrice 115, du substrat 102, sans nécessiter d'isolation électrique préalable. L'espace libre entre les parois 113 et la portion de matériau électriquement conducteur solidifié 115 peut être laissé tel quel ou rempli par exemple à l'aide d'un polymère isolant, par exemple du benzocyclobutène, du polyimide, etc.

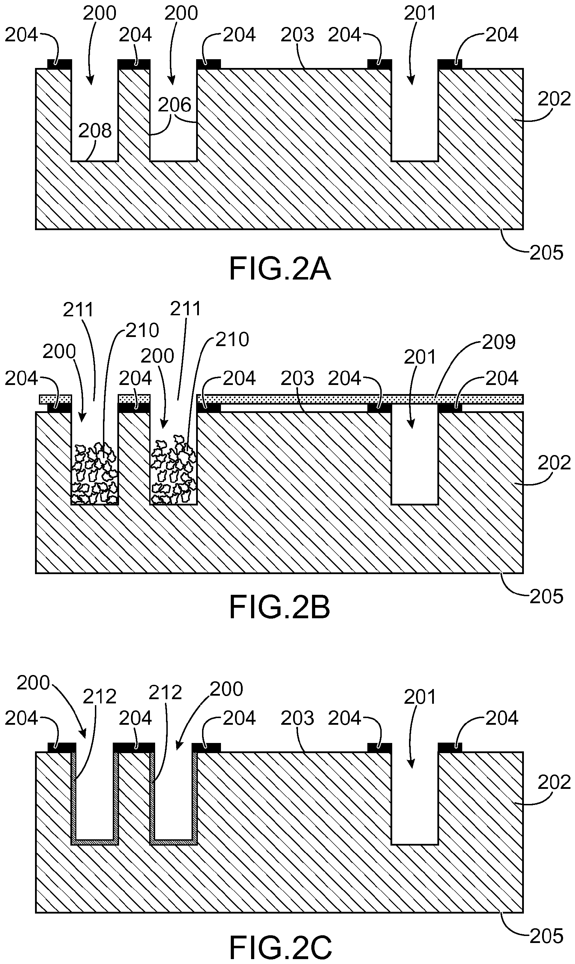

On se réfère maintenant aux figures 2A à 2D qui représentent les étapes d'un procédé de métallisation de vias borgnes 200 selon un second mode de réalisation.

Comme représenté sur la figure 2A, les vias borgnes 200 sont réalisés dans un substrat 202, par exemple de nature et de dimensions similaires à celles du premier substrat 102 précédemment décrit. Toutefois, contrairement au via 100, les vias 200 ne traversent pas le substrat 202 et comportent chacun une seule ouverture au niveau d'une face supérieure 203 du substrat 202. Des contacts électriques 204 sont également réalisés sur la face supérieure 203 du substrat 202, en périphérie des ouvertures des vias 200. Un autre via borgne 201, qu'on ne souhaite pas métalliser en même temps que les vias borgnes 200, est également réalisé dans le substrat 202.

Chacun des vias borgnes 200 comporte des parois latérales 206 ainsi qu'une paroi de fond 208 formés dans le substrat 202. Dans ce second mode de réalisation, les parois latérales 206 et les parois de fond 208 des vias 200 sont traitées de manière à les rendre mouillantes vis-à-vis du matériau électriquement conducteur qui sera utilisé par la suite pour métalliser les vias borgnes 200. Ce traitement peut par exemple consister en un dépôt d'un matériau adapté, par exemple un alliage de nickel et d'or, sur les parois latérales 206 et les parois de fond 208 des vias borgnes 200.

Etant donné que l'on ne souhaite pas métalliser le via borgne 201, on dispose un masque 209 contre la face supérieure 203 du substrat 202. Ce masque 209 comporte des ouvertures 211 qui sont alignées sensiblement avec les vias borgnes 200 que l'on souhaite métalliser. Par contre, l'ouverture du via borgne 201 que l'on ne souhaite pas métalliser est bouchée par le masque 209. Le masque 209 peut par exemple comporter une feuille d'acier inox usinée par laser et plaquée mécaniquement sur le substrat 202, ou comporter un substrat, par exemple à base de silicium, préalablement gravé par laser ou par gravure profonde et plaqué mécaniquement sur le substrat 102.

Des portions solides 210 d'un matériau électriquement conducteur, par exemple de même nature que celui des microbilles 110 précédemment décrites, sont ensuite éparpillées sur le masque 209. Les portions solides 210 ne sont pas des microbilles et forment des granules de formes aléatoires. On met ensuite en vibration le substrat 202 afin que des quantités souhaitées de portions solides 210 tombent dans les vias borgnes 200 à métalliser. Le surplus de portions solides 210 encore présent sur le substrat 200 est ensuite retiré, par exemple en réalisant un soufflage doux au niveau du masque 209 (figure 2B). Le masque 209 est ensuite retiré.

De manière analogue au procédé précédemment décrit en liaison avec les figures 1A à 1F, on réalise ensuite un traitement thermique faisant fondre les portions solides 210 de matériau électriquement conducteur. En raison du traitement précédemment réalisé pour rendre les parois latérales 206 et les parois de fond 208 mouillantes vis-à-vis du matériau des portions solides 210, le matériau fondu des portions solides 210 ne s'accumule pas au fond des vias 200 mais vient mouiller les parois latérales 206 et les parois de fond 208 des vias borgnes 200. En refroidissant, les vias 200 se retrouvent donc métallisés au niveau de leurs parois latérales 206 et de leur paroi de fond 208 recouvertes par une couche 212 de métallisation à base de matériau électriquement conducteur (figure 2C). De plus, étant donné que les contacts électriques 204 sont disposés en périphérie des ouvertures des vias 200 et que les couches 212 électriquement conductrices remontent jusqu'au niveau des ouvertures des vias 200 au niveau de la face supérieure 203 du substrat 202, des contacts électriques sont crées entre les couches de métallisation 212 et les contacts électriques 204 au niveau de chacun des vias 200.

Le procédé est ensuite achevé en réalisant un amincissement du substrat 202 au niveau d'une face arrière 205 du substrat 202, par exemple en mettant en oeuvre une planarisation mécano-chimique avec arrêt sur la couche de métallisation 212. Ainsi, les contacts électriques 204 sont électriquement accessibles depuis une face arrière 207 du substrat 202 aminci par l'intermédiaire des couches de métallisation 212.

Dans une variante, et de manière analogue au premier mode de réalisation, il est possible de ne pas réaliser un traitement préalable des parois latérales 206 et des parois de fond 208 des vias 200 pour rendre ces parois mouillantes vis-à-vis du matériau de métallisation utilisé. Dans ce cas, les métallisations des vias 200 obtenues seront analogues à celles réalisées pour les vias 100, c'est-à-dire formées par des portions de matériau électriquement conducteur remplissant totalement ou partiellement l'espace dans les vias.

Dans un autre mode de réalisation, la métallisation des vias peut consister à réaliser tout d'abord un remplissage partiel des vias par un matériau électriquement conducteur tel que représenté sur la figure 1C, puis de poursuivre la métallisation des vias en formant une couche électriquement conductrice le long des portions des parois latérales des vias se trouvant au-dessus des portions de matériau électriquement conducteur précédemment solidifié dans les vias.

Les procédés de métallisation précédemment décrits s'appliquent particulièrement pour métalliser des vias borgnes formés dans un dispositif imageur, les vias pouvant s'étendre depuis la partie optique supérieure de l'imageur jusqu'à la partie électronique inférieure. Ainsi, il est possible de reprendre les contacts électriques de la partie électronique depuis la partie optique de l'imageur.

Bien que les vias 100, 200 et 300 précédemment décrits aient tous une section en forme de disque, le procédé de métallisation précédemment décrit peut s'appliquer à des vias de n'importe quelle forme et de toutes dimensions à partir du moment qu'il est possible d'introduire au moins une portion solide, également de n'importe quelle forme, de matériau électriquement conducteur dans le via borgne.

## Revendications

1. Procédé de métallisation d'au moins un via borgne (100, 200, 300) formé dans au moins un substrat (102, 202), comportant au moins les étapes suivantes :
a) disposer au moins une portion solide (110, 210) de matériau électriquement conducteur dans le via borgne (100, 200, 300),
b) réaliser un traitement thermique de la portion solide (110, 210) de matériau électriquement conducteur, la faisant fondre dans le via borgne (100, 200, 300),
c) réaliser un refroidissement du matériau électriquement conducteur (112, 114, 115, 116, 212), le solidifiant dans le via borgne (100, 200, 300),
**caractérisé en ce que**, préalablement à la mise en oeuvre de l'étape a), au moins une partie des parois (113) du via borgne (300) est recouverte d'un matériau apte à empêcher le mouillage de ladite partie des parois (113) du via borgne (300) par le matériau électriquement conducteur fondu obtenu lors de la mise en oeuvre de l'étape b), le matériau électriquement conducteur solidifié (115) obtenu après la mise en oeuvre de l'étape c) étant non solidaire de ladite partie des parois (113) du via borgne (300) non mouillante,
et dans lequel le matériau apte à empêcher le mouillage de ladite partie des parois du via borgne (300) forme un angle de goutte, avec le matériau électriquement conducteur fondu, égal à environ 180° et/ou correspond à un matériau fluoré ou comporte du PDMS, du silicone, du téflon, ou un dérivé de ces composants.

2. Procédé selon la revendication 1, dans lequel la portion solide de matériau électriquement conducteur est une microbille (110).

3. Procédé selon la revendication 2, dans lequel, préalablement à l'étape a), la microbille (110) est disposée sur une face (103) du substrat (102) au niveau de laquelle le via borgne (100) est débouchant, puis poussée et/ou roulée dans le via borgne (100) au cours de l'étape a).

4. Procédé selon la revendication 1 ou 2, dans lequel, préalablement à l'étape a), la portion solide (210) de matériau électriquement conducteur est disposée sur une face (203) du substrat (202) au niveau de laquelle le via borgne (200) est débouchant, et dans lequel, au cours de l'étape a), la portion solide (210) de matériau électriquement conducteur est disposée dans le via borgne (200) par une mise en vibration du substrat (202).

5. Procédé selon l'une des revendications précédentes, dans lequel le via borgne (100) traverse le substrat (102), appelé premier substrat, tel que le via borgne (100) soit débouchant au niveau de deux faces (103, 105) opposées du premier substrat (102), une paroi de fond du via borgne (100) étant formée par au moins un second substrat (104) solidarisé au premier substrat (102).

6. Procédé selon l'une des revendications précédentes, dans lequel au moins un contact électrique (108, 109, 204) est disposé sensiblement au niveau d'une paroi de fond du via borgne (100), et/ou sur au moins une face (103, 105, 203) du substrat (102, 202) au niveau de laquelle le via borgne (100, 200) est débouchant et tout ou partie en périphérie du via borgne (100, 200), le matériau électriquement conducteur solidifié (112, 114, 116, 212) obtenu après la mise en oeuvre de l'étape c) étant relié électriquement audit contact électrique (108, 109, 204).

7. Procédé selon l'une des revendications précédentes, dans lequel la mise en oeuvre des étapes a) à c) est répétée plusieurs fois, augmentant la quantité de matériau électriquement conducteur solidifié (114, 116) dans le via borgne (100) à chaque mise en oeuvre ultérieure de l'étape c) par rapport à la quantité de matériau électriquement conducteur solidifié (112, 114) lors d'une précédente mise en oeuvre de l'étape c).

8. Procédé selon la revendication 7, dans lequel, lors d'une mise en oeuvre ultérieure de l'étape a), les dimensions de la portion solide (110) de matériau électriquement conducteur utilisée sont inférieures aux dimensions de la portion solide (110) de matériau électriquement conducteur utilisée lors d'une précédente mise en oeuvre de l'étape a).

9. Procédé selon l'une des revendications précédentes, dans lequel la mise en oeuvre des étapes a) à c) réalise simultanément la métallisation de plusieurs vias borgnes (200) formés au moins dans le substrat (202).

10. Procédé selon la revendication 9, dans lequel, préalablement à la mise en oeuvre de l'étape a), un masque (209) est disposé sur une face (203) du substrat (202) au niveau de laquelle les vias borgnes (200) sont débouchant, le masque (209) comportant au moins une ouverture (211) alignée avec au moins un des vias borgnes (200).

## Patentansprüche

1. Verfahren zur Metallisierung mindestens einer Blindloch-Durchkontaktierung (100, 200, 300), die in mindestens einem Substrat (102, 202) ausgebildet ist, wobei es zumindest die folgenden Schritte beinhaltet:
a) Anordnen mindestens einer fest vorliegenden Portion (110, 210) von elektrisch leitendem Material in der Blindloch-Durchkontaktierung (100, 200, 300),
b) Durchführen einer thermischen Behandlung der fest vorliegenden Portion (110, 210) von elektrisch leitendem Material, wodurch dieses in der Blindloch-Durchkontaktierung (100, 200, 300) zum Schmelzen gebracht wird,
c) Durchführen einer Abkühlung des elektrisch leitenden Materials (112, 114, 115, 116, 212), wobei dieses in der Blindloch-Durchkontaktierung (100, 200, 300) verfestigt wird,
**dadurch gekennzeichnet, dass**
vor der Durchführung von Schritt a) mindestens ein Teil der Wände (113) der Blindloch-Durchkontaktierung (300) mit einem Material überzogen wird, das geeignet ist, das Benetzen dieses Teils der Wände (113) der Blindloch-Durchkontaktierung (300) durch das geschmolzene elektrisch leitende Material zu verhindern, welches man während der Durchführung von Schritt b) erhält, wobei das verfestigte elektrisch leitende Material (115), das nach Durchführung von Schritt c) erhalten wird, mit diesen nicht-benetzenden Teil der Wände (113) der Blindloch-Durchkontaktierung (300) nicht fest verbunden ist,
und wobei das Material, das geeignet ist, das Benetzen des Teils der Wände der Blindloch-Durchkontaktierung (300) zu verhindern, mit dem geschmolzenen elektrisch leitenden Material einen Tropfen-Kontaktwinkel bildet, der ungefähr 180° beträgt, und/oder einem fluorierten Material entspricht oder PDMS, Silikon, Teflon oder ein Derivat dieser Bestandteile enthält.

2. Verfahren nach Anspruch 1, wobei die fest vorliegende Portion von elektrisch leitendem Material eine Mikrokugel (110) ist.

3. Verfahren nach Anspruch 2, wobei vor Schritt a) die Mikrokugel (110) auf einer Fläche (103) des Substrats (102) angeordnet wird, bei der die Blindloch-Durchkontaktierung (100) mündet, und dann im Verlauf von Schritt a) in die Blindloch-Durchkontaktierung (100) hineingeschoben und/odergerollt wird.

4. Verfahren nach Anspruch 1 oder 2, wobei vor Schritt a) die fest vorliegende Portion (210) von elektrisch leitendem Material auf einer Fläche (203) des Substrats (202) angeordnet wird, bei der die Blindloch-Durchkontaktierung (200) mündet, und wobei im Verlauf von Schritt a) die fest vorliegende Portion (210) von elektrisch leitendem Material in der Blindloch-Durchkontaktierung (200) durch In-Vibration-Versetzen des Substrats (202) angeordnet wird.

5. Verfahren nach einem der vorhergehenden Ansprüche, wobei die Blindloch-Durchkontaktierung (100) durch das Substrat (102) hindurchgeht, das als erstes Substrat bezeichnet wird, derart, dass die Blindloch-Durchkontaktierung (100) bei zwei gegenüberliegenden Flächen (103, 105) des ersten Substrats (102) mündet, wobei eine Wand des Bodens der Blindloch-Durchkontaktierung (100) durch mindestens ein zweites Substrat (104) gebildet wird, das mit dem ersten Substrat (102) fest verbunden ist.

6. Verfahren nach einem der vorhergehenden Ansprüche, wobei mindestens ein elektrischer Kontakt (108, 109, 204) im Wesentlichen bei einer Wandung des Bodens der Blindloch-Durchkontaktierung (100) und/oder auf mindestens einer Fläche (103, 105, 203) des Substrates (102, 202) angeordnet ist, bei der die Blindloch-Durchkontaktierung (100, 200) mündet, und zwar insgesamt oder teilweise am Umfang der Blindloch-Durchkontaktierung (100, 200), wobei das verfestigte elektrisch leitende Material (112, 114, 116, 212), das nach der Durchführung von Schritt c) erhalten wird, mit dem elektrischen Kontakt (108, 109, 204) elektrisch verbunden ist.

7. Verfahren nach einem der vorhergehenden Ansprüche, wobei die Durchführung der Schritte a) bis c) mehrmals wiederholt wird, wodurch die Menge an verfestigtem elektrisch leitenden Material (114, 116) in der Blindloch-Durchkontaktierung (100) mit jeder weiteren Durchführung von Schritt c) bezüglich der Menge an verfestigtem elektrisch leitenden Material (112, 114), die bei einer vorhergehenden Durchführung von Schritt c) erzielt wurde, erhöht wird.

8. Verfahren nach Anspruch 7, wobei bei einer nachmaligen Durchführung von Schritt a) die Abmessungen der verwendeten fest vorliegenden Portion (110) von elektrisch leitendem Material geringer als die Abmessungen der fest vorliegenden Portion (110) an elektrisch leitendem Material sind, die man bei einer vorhergehenden Durchführung von Schritt a) verwendet hat.

9. Verfahren nach einem der vorhergehenden Ansprüche, wobei mittels der Durchführung der Schritte a) bis c) gleichzeitig die Metallisierung von mehreren Blindloch-Durchkontaktierungen (200), die zumindest in dem Substrat (202) ausgebildet sind, realisiert wird.

10. Verfahren nach Anspruch 9, wobei vor der Durchführung von Schritt a) eine Maske (209) auf einer Fläche (203) des Substrates (202) angeordnet wird, bei der die Blindloch-Durchkontaktierungen (200) münden, wobei die Maske (209) mindestens eine Öffnung (211) aufweist, die mit mindestens einer der Blindloch-Durchkontaktierungen (200) fluchtet.

## Claims

1. A method for metalizing at least one blind via (100, 200, 300) formed in at least one substrate, including at least the following steps:
a) arranging at least one solid portion (110, 210) of electrically conductive material in the blind via (100, 200, 300),
b) performing a thermal treatment of the solid portion (110, 210) of electrically conductive material, making it melt in the blind via (100, 200, 300) ,
c) cooling the electrically conductive material (112, 114, 115, 116, 212), solidifying it in the blind via (100, 200, 300),
**characterized in that**, before carrying out step a), at least part of the walls (113) of the blind via (300) is covered with a material able to prevent wetting of said part of the walls (113) of the blind via (300) by the melted electrically conductive material obtained during the performance of step b), the solidified electrically conductive material (115) obtained after carrying out step c) being able not to be secured to said non-wetting part of the walls (113) of the blind via (300),
and wherein the material able to prevent wetting of said part of the walls of the blind via (300) forms a drop angle, with the melted electrically conductive material, equal to about 180° and/or corresponds to a fluorinated material or comprises PDMS, silicone, Teflon, or a derivative of these components.

2. The method according to claim 1, wherein the solid portion of electrically conductive material is a microbead (110).

3. The method according to claim 2, wherein, before step a), the microbead (110) is positioned on a face (103) of the substrate (102) at which the blind via (100) emerges, then pushed and/or rolled in the blind via (100) during step a).

4. The method according to one of claims 1 or 2, wherein, before step a), the solid portion (210) of electrically conductive material is positioned on one face (203) of the substrate (202) at which the blind via (200) emerges, and wherein, during step a), the solid portion (210) of electrically conductive material is positioned in the blind via (200) by making the substrate (202) vibrate.

5. The method according to one of previous claims, wherein the blind via (100) passes through the substrate (102), called first substrate, such that the blind via (100) emerges at two opposite faces (103, 105) of the first substrate (102), a bottom wall of the blind via (100) being formed by at least one second substrate (104) secured to the first substrate (102).

6. The method according to one of previous claims, wherein at least one electrical contact (108, 109, 204) is positioned substantially at a bottom wall of the blind via (100), and/or on at least one face (103, 105, 203) of the substrate (102, 202) at which the blind via (100, 200) emerges and on all or part of the periphery of the blind via (100, 200), the solidified electrically conductive material (112, 114, 116, 212) obtained after carrying out step c) being electrically connected to said electrical contact (108, 109, 204).

7. The method according to one of previous claims, wherein the implementation of steps a) to c) is repeated several times, increasing the quantity of solidified electrically conductive material (114, 116) in the blind via (100) upon each subsequent implementation of step c) relative to the amount of electrically conductive material (112, 114) solidified during a preceding performance of step c).

8. The method according to claim 7, wherein, during a subsequent performance of step a), the dimensions of the solid portion (110) of electrically conductive material used are smaller than the dimensions of the solid portion (110) of electrically conductive material used during a preceding performance of step a).

9. The method according to one of previous claims, wherein the performance of steps a) to c) simultaneously performs the metallization of several blind vias (200) formed at least in the substrate (202).

10. The method according to claim 9, wherein, before performing step a), a mask (209) is positioned on one face (203) of the substrate (202) at which the blind vias (200) emerge, the mask (209) including at least one opening (211) aligned with at least one of the blind vias (200) .
